# FASCICULE DE BREVET EUROPEEN

(11) **EP 3 202 014 B1**
(45) Date de publication et mention de la délivrance du brevet: **18.07.2018**
(21) Numéro de dépôt: 15781129.0
(22) Date de dépôt: 29.09.2015
(51) Int. Cl.: H02J 7/14, H02J 7/16, H02P 9/02, H02K 11/30

(54) **DISPOSITIF DE COMMANDE D'UN REGULATEUR D'UN ALTERNATEUR D'UN VEHICULE AUTOMOBILE ET ALTERNATEUR COMPRENANT LE REGULATEUR CORRESPONDANT**
STEUERVORRICHTUNG FÜR EINEN LICHTMASCHINENREGLER EINES KRAFTFAHRZEUGS UND LICHTMASCHINE MIT ENTSPRECHDENDEM REGLER
CONTROL DEVICE FOR A REGULATOR OF A MOTOR VEHICLE ALTERNATOR AND ALTERNATOR WITH CORRESPONDING REGULATOR

(30) Priorité: 30.09.2014 FR 1459227
(43) Date de publication de la demande: 09.08.2017
(73) Titulaire: Valeo Equipements Electriques Moteur, 94046 Créteil Cedex (FR)
(72) Inventeur: CHASSARD, Pierre, 94000 Creteil (FR); TISSERAND, Pierre, 94450 Limeil Brevannes (FR); DE LAMARRE, Laurent, 75020 Paris (FR); ARROU, Thibault, 92150 Suresnes (FR)
(74) Mandataire: Duprez, Richard
(86) Numéro de dépôt international: PCT/FR2015/052599
(87) Numéro de publication internationale: WO 2016/051075

(56) Documents cités:
- EP-A1- 0 720 271
- EP-A1- 0 783 994
- EP-A2- 0 822 654
- FR-A1- 2 674 063

## Description

### DOMAINE TECHNIQUE DE L'INVENTION.

La présente invention concerne un dispositif de commande d'un régulateur d'un alternateur d'un véhicule automobile, ainsi que l'alternateur comprenant le régulateur adapté à ce dispositif de commande.

### ARRIERE PLAN TECHNOLOGIQUE DE L'INVENTION.

Classiquement, un régulateur d'un alternateur de véhicule automobile est mis en service à l'initiative du conducteur par une clé de contact du véhicule. Avec un régulateur dit "mono fonction", le régulateur est relié à la clé de contact via une lampe témoin de défaut.

Dans des régulateurs plus sophistiqués come les régulateurs dits "multifonctions" ou pilotés, la circuiterie du régulateur est alimentée en permanence, mais doit passer d'un état de repos ou veille, de consommation réduite, à un état actif lorsqu'on détecte que la clé de contact est fermée.

Mais pour obtenir une compatibilité de câblage de ces régulateurs multifonctions avec des régulateurs mono fonction, il n'est pas possible de réaliser une liaison directe entre la clé de contact et le régulateur, ce qui impose de détecter la fermeture de la clé à travers la lampe témoin de défaut.

Pratiquement, le problème central d'une telle détection réside dans la discrimination qui doit être effectuée entre le cas où la clé est ouverte et la lampe éteinte, auquel cas une borne de la lampe côté régulateur est au potentiel d'une masse grâce à une résistance de tirage, et le cas où la clé est fermée mais où la lampe, à cause de l'existence d'un défaut, est allumée, auquel cas la borne de la lampe côté régulateur est à un potentiel fixé, par exemple par une tension de déchet d'un élément de commutation à semi-conducteur qui alimente la lampe. Et plus cette tension de déchet est faible, plus le potentiel de la borne de lampe côté régulateur est voisin de celui de la masse, ce qui rend difficile une discrimination entre les états ouvert et fermé de la clé.

Dans la demande de brevet FR2674063, la société VALEO EQUIPEMENTS ELECTRIQUES MOTEUR résout cette difficulté en mettant en oeuvre dans un circuit de détection un amplificateur différentiel commandant l'élément de commutation à semi-conducteur de la lampe à partir d'une différence entre un niveau de tension de la borne de la lampe côté régulateur et un niveau de référence, de manière à maintenir le potentiel de cette borne à un niveau suffisant pour ne pas désactiver le régulateur alors que l'alternateur présente un défaut mais que la clé de contact est fermée.

La discrimination entre les états ouvert et fermé de la clé est également rendue difficile par l'existence d'une résistance de fuite entre une borne de la batterie alimentant la lampe et la borne de la lampe du côté régulateur, court-circuitant la clé de contact.

Une telle résistance de fuite, qui est susceptible d'apparaître notamment sous l'effet de dépôts conducteurs, tels que des ponts salins créés lorsque le véhicule est exposé à des brouillards salins, peut présenter une valeur de 10 KΩ, voire aussi faible que 1 KΩ.

Le caractère variable de cette résistance de fuite en fonction de conditions d'ambiance rend aléatoire un pont diviseur de tension formé par cette résistance de fuite et la résistance de tirage fixe, rendant peut fiable une détection des états ouvert et fermé de la clé basée sur une comparaison à un niveau de référence unique et fixe.

Dans la demande de brevet FR2724268, la société VALEO EQUIPEMENTS ELECTRIQUES MOTEUR résout cette autre difficulté en équipant un circuit de détection de la fermeture d'une clé de contact pour la commande d'un régulateur de la charge d'une batterie pour un alternateur de moyens de dérivation des courants de fuites parasites circulant dans cette résistance de fuite.

Il est également connu des documents EP0783994, EP0822654, et EP0720271 un dispositif de commande d'un régulateur de tension d'alternateur de véhicule.

De Plus, de nos jours, des considérations écologiques conduisent les constructeurs d'automobiles à demander aux équipementiers de concevoir des alternateurs dont une tension de charge de la batterie de bord, fixée par une tension de consigne, est variable, de manière par exemple à limiter le couple prélevé sur le moteur thermique par l'alternateur ou à l'accroître en fonction d'une stratégie de pilotage d'une unité de contrôle moteur.

### DESCRIPTION GENERALE DE L'INVENTION.

La présente invention vise à apporter une solutions aux problèmes connus de l'état de la technique antérieur rappelés ci-dessus, notamment le problème des courants de fuite parasites.

Selon un premier aspect, l'invention concerne un dispositif de commande d'un régulateur d'un alternateur d'un véhicule automobile du type de ceux comportant, d'une part, un circuit de commande générant une commande d'activation du régulateur en portant à une première tension supérieure à une tension de référence haute prédéterminée une ligne de communication bidirectionnelle unifilaire connectée à, d'autre part, un circuit de détection d'un état de cette commande d'activation.

Le circuit de détection comprend des moyens de génération d'un signal de défaut à partir d'un drapeau signalant une défaillance de l'alternateur en reliant la ligne de communication à une masse par au moins un élément de commutation à semi-conducteur. De ce fait la ligne de communication est portée à une seconde tension inférieure à une tension de défaut prédéterminée inférieure à la tension de référence haute.

Le circuit de commande comprend des moyens de détection de ce signal de défaut.

Selon l'invention, dans un mode de réalisation général, le circuit de commande transmet en outre un signal de consigne modulé en largueur d'impulsion présentant une amplitude maximum supérieure à la tension de référence haute et une amplitude minimum inférieure à une tension de référence basse prédéterminée supérieure à la tension de défaut, un rapport cyclique de ce signal de consigne étant représentatif d'une tension de consigne du régulateur.

Adapté à ce circuit de commande, le circuit de détection comprend en outre, selon l'invention, un premier comparateur de tension, activé par des moyens d'activation en l'absence de défaillance de l'alternateur, qui compare un niveau de tension de la ligne de communication à un premier seuil de tension prédéterminé.

Dans un premier mode de réalisation particulier de l'invention, le circuit de détection comprend en outre un second comparateur de tension activé par ces moyens d'activation en cas de défaillance de l'alternateur et comparant le niveau de tension de la ligne de communication à un deuxième seuil de tension prédéterminé.

Selon l'invention, dans ce premier mode de réalisation, les moyens d'activation sont formés par une première porte logique ET connectée en entrée à une première sortie du premier comparateur de tension et à un drapeau complémentaire du drapeau signalant la défaillance de l'alternateur, et par une seconde porte logique ET connectée en entrée à une seconde sortie du second comparateur de tension et au drapeau. Les première et seconde portes logiques ET sont connectées en sortie à une porte logique OU de manière à reconstituer le signal de consigne émis par le circuit de commande sous la forme d'un signal modulé en largeur d'impulsion (PWM, acronyme de "Pulse Width Modulation" en terminologie anglaise).

Dans ce premier mode de réalisation de l'invention encore, le circuit de détection comprend en outre un amplificateur différentiel de tension amplifiant une différence entre le niveau de tension de la ligne de communication et un troisième seuil de tension prédéterminé, activé par le drapeau signalant la défaillance de l'alternateur et commandant l'élément de commutation à semi-conducteur.

Dans un second mode de réalisation de l'invention particulier, le circuit de détection comprend en outre un comparateur de courant activé par les moyens d'activation en cas de défaillance de l'alternateur et comparant une valeur du courant circulant dans l'élément de commutation à semi-conducteur à un seuil de courant prédéterminé.

Selon l'invention, dans ce second mode de réalisation, les moyens d'activation sont formés par un multiplexeur à deux voies commandé par le drapeau signalant la défaillance de l'alternateur, et connecté en entrée à une première sortie du premier comparateur de tension et à une seconde sortie du comparateur de courant de manière à reconstituer le signal de consigne émis par le circuit de commande.

Dans ce second mode de réalisation encore, ce comparateur de courant comprend par exemple un miroir de courant.

L'invention concerne aussi un alternateur de véhicule automobile du type de ceux comportant un régulateur intégré.

Selon l'invention, ce régulateur comprend un circuit de détection d'un dispositif de commande tel que décrit ci-dessus.

Ces quelques spécifications essentielles auront rendu évidents pour l'homme de métier les avantages apportés par l'invention par rapport à l'état de la technique antérieur.

Les spécifications détaillées de l'invention sont données dans la description qui suit en liaison avec les dessins ci-annexés.

Il est à noter que ces dessins n'ont d'autre but que d'illustrer le texte de la description et ne constituent en aucune sorte une limitation de la portée de l'invention.

### BREVE DESCRIPTION DES DESSINS.

La **Figure 1** montre schématiquement un dispositif de commande d'un régulateur d'un alternateur d'un véhicule automobile connu de l'état de la technique.
La **Figure 2** montre schématiquement un dispositif de commande d'un régulateur d'un alternateur d'un véhicule automobile selon l'invention, dans un mode de réalisation général.
La **Figure 3** montre schématiquement une partie d'un dispositif de commande d'un régulateur d'un alternateur d'un véhicule automobile selon l'invention, dans un premier mode de réalisation particulier.
La **Figure 4** montre schématiquement un dispositif de commande d'un régulateur d'un alternateur d'un véhicule automobile selon l'invention, dans un second mode de réalisation particulier.

### DESCRIPTION DES MODES DE REALISATION PREFERES DE L'INVENTION.

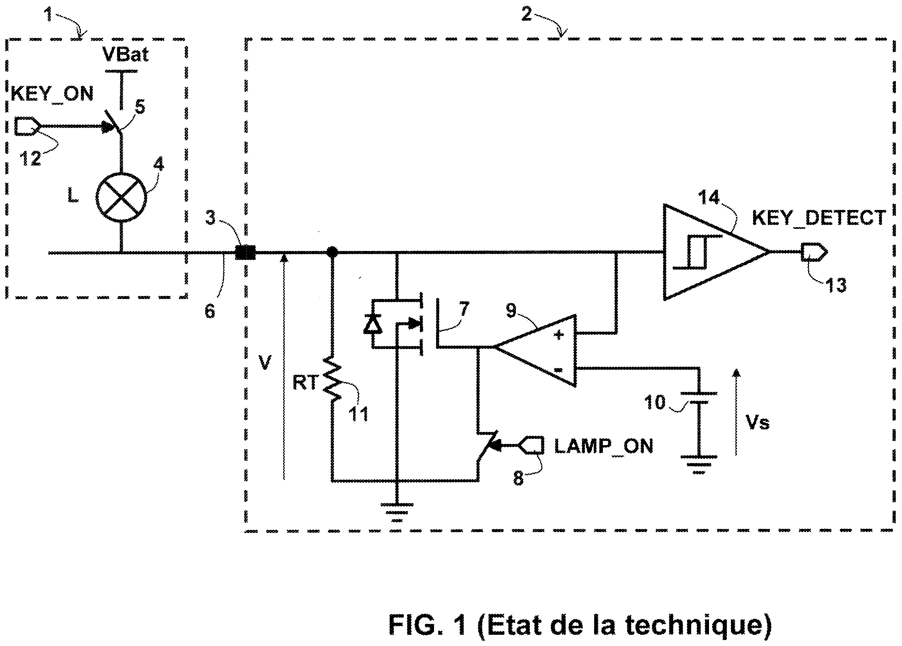

Pour un régulateur de type multifonction connu de l'état de la technique, dont la **Figure 1** montre un dispositif de commande comportant un circuit de commande 1 et un circuit de détection 2, les fonctionnalités d'activation et d'indication de défaut sont combinées sur la même borne de connexion 3 du régulateur.

Cette borne de connexion 3 est reliée au voyant 4 du tableau de bord du véhicule et au contacteur de clé 5, direct ou indirect.

L'activation du régulateur s'effectue par la détection d'une première tension, correspondant sensiblement au niveau de tension batterie VBat sur une ligne de communication 6 reliant le circuit de commande 1 au circuit de détection 2 lors de la commutation du contacteur de clé 5.

Pour signaler une défaillance de l'alternateur au conducteur, le circuit de détection 2 du régulateur tire le potentiel de la ligne de communication 6 à la masse avec un élément de commutation à semi-conducteur 7, formé par un transistor de puissance de type MOSFET, commandé par un drapeau LAMP_ON fourni sur une borne de statut 8 par l'alternateur défaillant, de manière à porter de ce fait une seconde tension de la ligne de communication 6 en dessous d'une tension de défaut prédéterminée et à faire circuler un courant dans la ligne de communication 6 permettant de signaler ce défaut.

Afin de ne pas désactiver le régulateur lors d'une indication de défaut, le niveau tension V de la ligne de communication 6 ne doit pas redescendre sous un seuil de détection Vs prédéterminé.

Ce niveau de tension est alors maintenu autour par exemple de 1,2 V par un moyen de pilotage 9, 10 du transistor de puissance 7, formé par un amplificateur différentiel 9 amplifiant une différence entre le niveau de tension de la ligne de communication 6 et le seuil de détection Vs fourni par une référence de tension 10 de 1,2 V par exemple.

Lorsque la clé 5 est déconnectée aucun potentiel n'est appliqué sur la ligne de communication 6, une résistance de tirage 11, de l'ordre de 8 KΩ, permettant de ramener le potentiel de la ligne 6 à une valeur proche de zéro.

Une séquence d'activation et de désactivation d'un régulateur, de type multifonction ou piloté, connu de l'état de la technique, fonctionnant sur le principe d'une combinaison des fonctions de lampe témoin 4 et de démarrage 5 sur la même borne de connexion 3, est par exemple la suivante:
Lors de la commutation du contacteur de clé 5 directement par le conducteur ou indirectement par un signal de mise en marche KEY_ON sur une borne de démarrage 12 passant à un état haut:
- la ligne de communication 6 est alimentée au travers la lampe 4 sous la tension de batterie VBat et le niveau de tension augmente;
- lorsque le niveau de tension V dépasse le seuil de détection Vs, la commande d'activation KEY_DETECT fournie sur une borne de sortie 13 par un premier circuit comparateur à hystérésis 14 passe à l'état haut.

Si le niveau de tension V de la ligne de communication 6 reste au dessus du seuil de détection Vs pendant un délai de confirmation prédéterminé:
- le régulateur passe du mode veille au mode actif;
- le régulateur tire le potentiel de la ligne de communication 6 à la masse de manière à faire circuler un courant dans la ligne de communication 6 et allumer la lampe témoin 4 pour signaler que l'alternateur ne charge pas la batterie;
- le niveau de tension V de la ligne de communication 6 chute mais est maintenu, par le moyen de pilotage 9, 10, au dessus du seuil de détection Vs et le régulateur reste en mode actif.

Lors de l'arrêt du véhicule, le commutateur de clé 5 est ouvert, directement par le conducteur ou indirectement par le signal de mise en marche KEY_ON sur la borne de démarrage 12 passant à un état bas:
- le moyen de pilotage 9, 10 ne peut plus maintenir la tension sur la ligne de communication 6, donc le niveau de tension V chute sous le seuil de détection Vs;
- la commande d'activation KEY_DETECT fournie sur la borne de sortie 13 par le premier circuit comparateur 14 retourne à l'état bas.

Passé le délai de confirmation prédéterminé, si le niveau de tension V sur la ligne de communication 6 est restée sous le seuil de détection Vs:
- le régulateur retourne en mode de veille.
- le transistor de puissance 7 commutant la lampe témoin 4 n'est plus commandé.

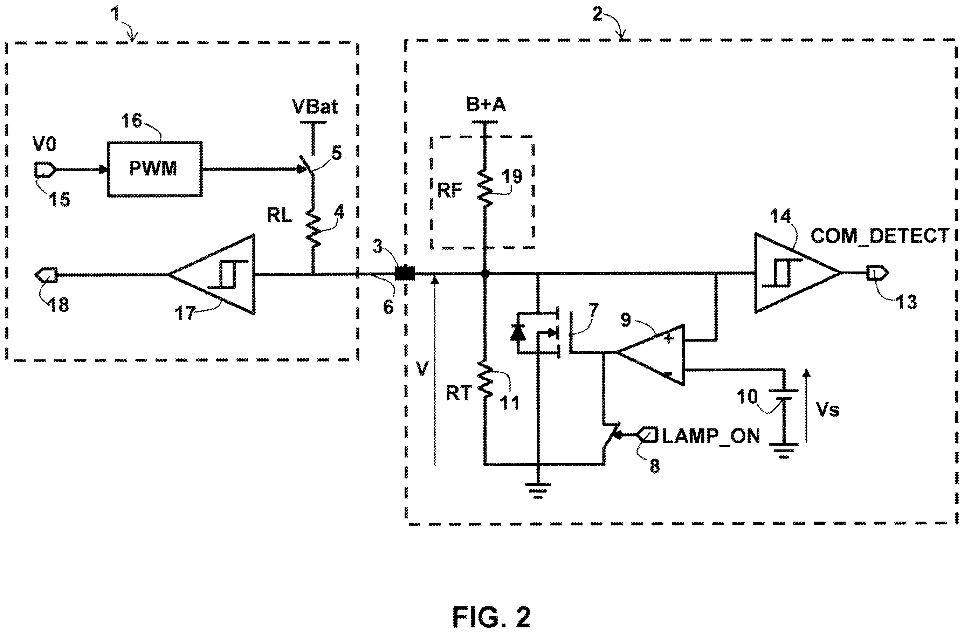

Conformément au but de l'invention, pour répondre à la demande d'un alternateur fournissant une tension de charge programmable, le dispositif de commande montré sur la **Figure 1** est modifié comme montré sur la **Figure 2** pour implémenter un protocole de communication entre le circuit de commande 1 et le circuit de détection 2 permettant à un module de contrôle moteur (non représenté) de fixer une tension de consigne V0 du régulateur sur une borne de contrôle 15.

La lampe témoin 4 est remplacée par une résistance de charge 4, de l'ordre de 470 Ω par exemple, et un circuit de contrôle 16 qui émet sur la ligne de communication 6 un signal de consigne modulé en PWM. La valeur du rapport cyclique correspond à la consigne de régulation de tension. Une amplitude du signal de consigne dépend du mode de fonctionnement du régulateur.

En mode normal sans indication de défaut, le circuit de contrôle 16 impose une première tension supérieure à une tension de référence haute sur la ligne de communication 6. Quand le tirage haut est relâché par le circuit de contrôle 16, la résistance de tirage 11 à la masse du régulateur ramène le niveau de tension V sur la ligne de communication 6 à une seconde tension inférieure à une tension de référence basse, proche de 0 V.

Lorsque le régulateur indique une défaillance de l'alternateur, un maximum du signal de consigne est limité au seuil de détection Vs, c'est-à-dire à 1,2 V par exemple, par le moyen de pilotage 9, 10 du transistor de puissance 7, tandis qu'un minimum de ce signal de consigne est ramené en dessous de la tension de défaut, à sensiblement 0 V, à la fois par le transistor de puissance 7 et la résistance de tirage 11 à la masse.

Dans le mode général de réalisation de l'invention montré sur la **Figure 2****,** la détection du signal de consigne par le régulateur s'effectue sans modification de son circuit de détection 2 par rapport au montage connu de l'état de la technique montré sur la **Figure 1****.**

En effet, dans les deux modes de fonctionnement, le niveau de tension sur la ligne de communication 6 redescend à 0 V et croise le seuil de détection Vs de fermeture de la clé 5. Le signal de consigne émis par le circuit de contrôle 16 peut donc être détecté par le premier circuit comparateur 14, recomposé sur la borne de sortie 13 et envoyé à un circuit de contrôle logique du régulateur, qui doit être adapté afin de calculer la tension de consigne V0 à appliquer à l'alternateur à partir de ce signal détecté COM_DETECT.

La lampe témoin 4 de charge de la batterie sur le tableau de bord du véhicule n'étant plus commutée directement par le circuit de détection 2 du régulateur, le circuit de commande 1 doit pouvoir détecter le tirage en dessous de la tension de défaut, c'est-à-dire à moins de 1 V, de la ligne de communication 6 lors du signalement de la défaillance de l'alternateur. Pour ce faire, un second circuit comparateur à hystérésis 17 placé dans le circuit de commande 1 détecte l'absence d'activité sur la ligne de communication 6 et peut remonter cette information à un module de contrôle habitacle (non représenté) via une borne de signalisation 18.

La transmission au régulateur de la tension de consigne V0 fournie par le module de contrôle moteur et l'indication de défaut transmise par le régulateur au module de contrôle habitable peuvent être simultanées: la ligne de communication 6 entre le circuit de commande 1 et le circuit de détection 2 est une liaison de type full duplex.

La séquence d'activation et de désactivation d'un régulateur, de type multifonction ou piloté, d'un alternateur programmable selon l'invention, dans le mode de réalisation général du dispositif de commande représenté sur la **Figure 2****,** est typiquement la suivante:
- le réveil du régulateur est identique à celui du régulateur multifonction non programmable;
- lorsque le circuit de commande 1 relâche la ligne de communication 6, le régulateur ne retourne pas dans l'immédiat en mode veille. Le régulateur reste actif dans l'attente d'un nouveau front montant sur la ligne de communication 6;
- au cycle suivant du signal de consigne, le rapport cyclique est déterminé puis interprété par le circuit de contrôle logique du régulateur qui applique une loi de commande voulue;
- le régulateur retourne en mode veille à condition que le niveau de tension sur la ligne de communication 6 reste sous le seuil de détection Vs pendant le délai de confirmation prédéterminé.

L'inconvénient de cette approche générale est sa sensibilité aux courants de fuite qui peuvent apparaître au cours de la vie du dispositif de commande 1, 2 entre une borne de puissance B+A de l'alternateur alimentant la batterie et la borne de connexion 3 du régulateur vers le circuit de commande 1, par exemple à cause d'un pont salin, type de problèmes déjà indiqué en préambule.

En mode de fonctionnement normal, la résistance équivalente de fuite 19 a tendance à faire remonter le niveau de tension sur la ligne de communication 6 sur un état bas du signal de consigne. L'effet peut être que le minimum du signal de consigne soit toujours supérieur à la tension de référence basse et donc que le rapport cyclique du signal de consigne ne puisse plus être interprété. Le régulateur ne pourrait également plus retourner en mode de veille lors des cycles de vie passive du véhicule, ce qui contribuerait à décharger de la batterie.

Afin de pallier cet inconvénient, des spécifications du protocole de communication prennent en compte une élévation possible du niveau de tension V à l'état bas du signal de consigne en mode de fonctionnement normal en choisissant de manière appropriée les tensions de référence haute et basse, ainsi que la tension de défaut.

Dans les modes de réalisation préférés de l'invention la tension de référence haute est égale à 3,5 V par exemple, la tension de référence basse est égale à 1,5 V par exemple et la tension de défaut est de l'ordre de 1 V.

Le minimum du signal de consigne est donc compris en 0 V et 1,5 V par exemple selon ces spécifications en mode de fonctionnement normal. Mais en cas de défaut, le niveau de tension V est toujours inférieur à 1 V. Il n'existe par conséquent pas de plage de détection commune aux deux modes de fonctionnement. De ce fait, deux méthodes de détection sont implémentées dans le circuit de détection 2 du dispositif de commande 1, 2 d'un régulateur selon l'invention: l'une lorsque l'amplitude des signaux est importante, l'autre en mode de défaut avec des niveaux de tensions plus faibles.

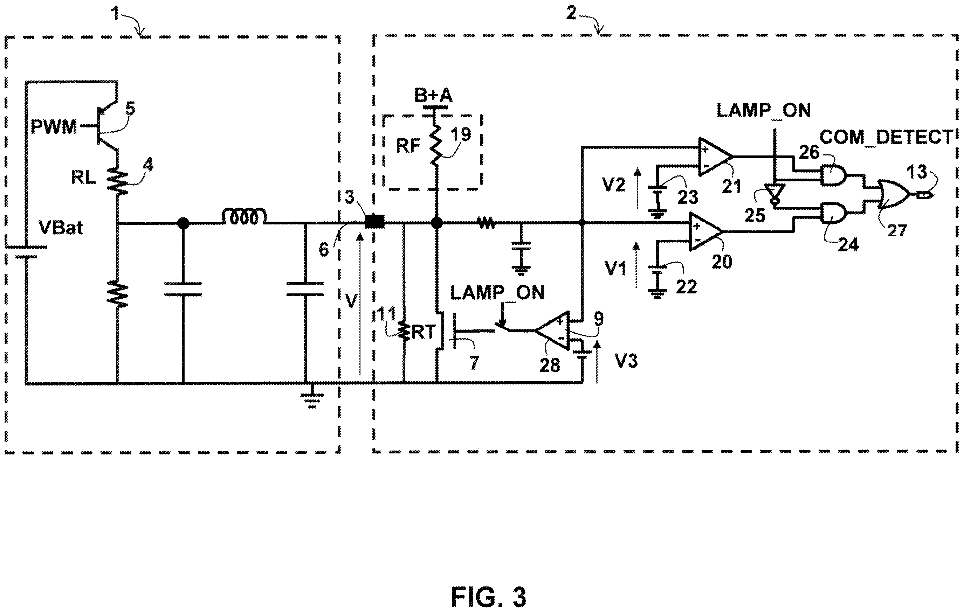

Dans un premier mode réalisation particulier, montré schématiquement sur la **Figure 3****,** le circuit de détection 2 comprend des premier et second comparateurs de tension 20, 21 pour le signal de consigne dans les deux modes de fonctionnement

En mode normal, le premier comparateur de tension 20 compare le niveau de tension V sur la ligne de communication 6 à un premier seuil de tension prédéterminé V1 de 2,5 V fourni par une première source de référence 22.

En mode d'indication de défaut, le second comparateur de tension 21 compare le niveau de tension V sur la ligne de communication 6 à un second seuil de tension prédéterminé V2 de 0,65 V fourni par une seconde source de référence 23.

Le signal de consigne reconstitué COM_DETECT est fourni sur la borne de sortie 13 par le premier comparateur de tension 20 ou le second comparateur de tension 21 en fonction du mode.

Pour ce faire le circuit de détection 2 comprend:
- une première porte logique ET 24 connectée en entrée à une première sortie du premier comparateur de tension 20 et à un drapeau complémentaire du drapeau LAMP_ON formé par un inverseur 25;
- une seconde porte logique ET 26 connectée en entrée à une seconde sortie du second comparateur de tension 21 et au drapeau LAMP_ON;
- une porte logique OU 27 connectée en sortie des première et seconde portes logiques ET pour fournir le signal de consigne reconstitué COM_DETECT.

Dans ce premier mode de réalisation, l'amplificateur différentiel de tension 9 pilotant le transistor de puissance 7 amplifie la différence entre le niveau de tension V de la ligne de communication 6 et un troisième seuil de tension prédéterminé V3 de 0,9 V fourni par une troisième source de référence 28.

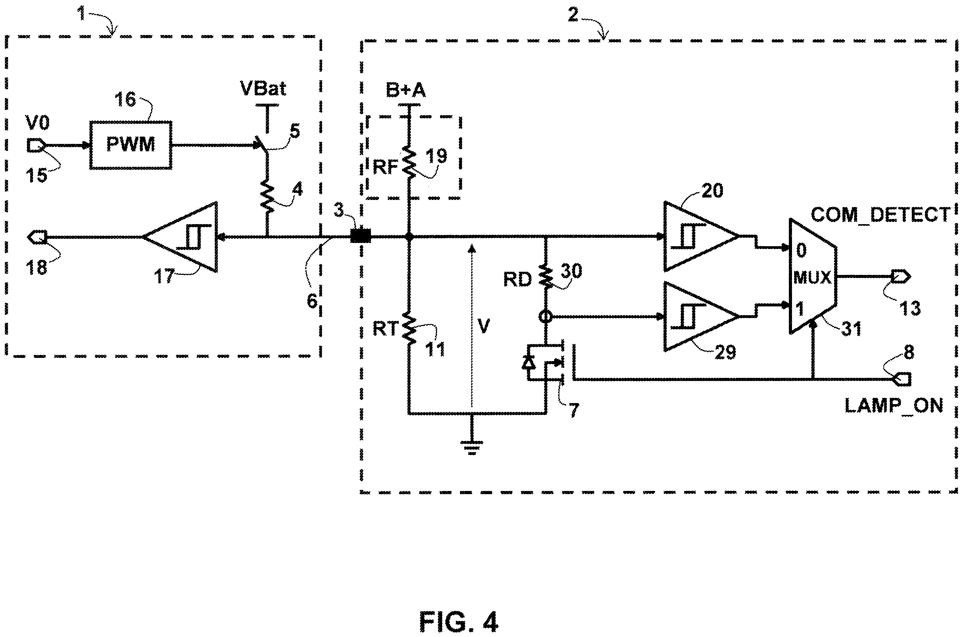

Un second mode de réalisation particulier de l'invention, montré schématiquement sur la **Figure 4****,** apporte une réponse dans ce cas.

Dans ce second mode de réalisation particulier, le circuit de détection 2 comprend le premier comparateur de tension 20 déjà mis en oeuvre dans le premier mode de réalisation de l'invention pour détecter le signal de consigne en mode de fonctionnement normal.

Le seuil de détection en tension se situe idéalement au dessus de la tension de décalage de masse et en dessous de la tension de référence haute.

La tension de référence haute égale à 3,5 V et la tension de référence basse égale à 1,5 V du protocole de communication conviennent le plus souvent en choisissant sans modification le premier seuil de tension prédéterminé auquel est comparé le niveau de tension de la ligne de communication égal à 2,5 V.

Pour effectuer une détection fiable en cas de défaut de la commande d'activation, indépendamment de la tension de décalage de masse, le circuit de détection 2 comprend un comparateur de courant 29.

Ce comparateur de courant 29 effectue une comparaison entre une valeur du courant circulant dans le transistor de puissance 7, commutant à la masse la ligne de communication 6 via une résistance de drain 30, de l'ordre de 100 Ω, et un seuil de courant prédéterminé. Ce seuil de courant correspond à une valeur minimum du courant permettant de ramener le niveau de tension V sur la ligne de communication 6 à la tension de défaut, soit 1 V.

De manière connue en soi, le comparateur de courant 29 comprend un miroir de courant, c'est-à-dire qu'il comprend un transistor de signal d'un type identique au transistor de puissance 7, mais de dimensions inférieures, connecté en parallèle sur le transistor de puissance 7. C'est donc un courant drain- source de ce transistor de signal, proportionnel au courant circulant dans le transistor de puissance 7 qui permet la comparaison avec le seuil de courant prédéterminé.

Lors du changement de son état en mode indication de défaut, le régulateur bascule de la mise en oeuvre du premier comparateur de tension 20 à la mise en oeuvre du comparateur de courant 29 pour la lecture du rapport cyclique.

Le signal de consigne est reconstitué COM_DETECT sur la borne de sortie 13 par un multiplexeur à deux voies 31 commandé par le drapeau LAMP_ON et connecté en entrée à une première sortie du premier comparateur de tension 20 et au comparateur de courant 29.

Afin que le rapport cyclique du signal de consigne soit interprété correctement, les signaux de sorties du premier comparateur de tension 20 et du comparateur de courant 29 doivent se recouvrir au moment de la bascule entre modes de fonctionnement. Ainsi la discontinuité sera minimisée dans la lecture du rapport cyclique. Pour ce faire, le basculement du mode normal en mode défaut est synchronisé avec un état bas du signal de consigne.

Dans le mode de réalisation général et les premier et second modes de réalisation particuliers de l'invention, le circuit de détection 2 du dispositif de commande 1, 2 d'un régulateur selon l'invention est réalisé sous la forme d'un ASIC (acronyme en terminologie anglaise de l'expression "Application Specific Integrated Circuit", c'est-à-dire "circuit intégré pour application spécifique").

Ce type de circuit intégré permet de respecter facilement les spécifications diverses à prévoir des constructeurs d'automobiles, concernant notamment le protocole de communication et portant sur la tension de référence haute, la tension de référence basse, et la tension de défaut, pour satisfaire toutes les demandes d'alternateurs programmables de nouvelle génération.

Comme il va de soi l'invention ne se limite pas aux seuls modes de réalisation préférentiels décrits ci-dessus.

Notamment, les valeurs des composants électroniques passifs, tels que les résistances 4, 11, 19, 30 et les types de composants électroniques actifs 7, 9, 14, 17, 20, 21, 24, 25, 26, 27, 28, 29, 31 indiqués ne sont que des exemples: l'homme de métier utilisera autant que de besoin d'autres composants électronique pour remplir les mêmes fonctions.

L'invention embrasse donc toutes les variantes possibles de réalisation dans la mesure où ces variantes restent dans le cadre défini par les revendications ci-après.

## Revendications

1. Dispositif de commande (1, 2) d'un régulateur d'un alternateur d'un véhicule automobile du type de ceux comportant, d'une part, un circuit de commande (1) générant une commande d'activation (KEY_ON) dudit régulateur en portant à une première tension supérieure à une tension de référence haute prédéterminée une ligne de communication (6) bidirectionnelle unifilaire connectée à, d'autre part, un circuit de détection (2) d'un état (KEY_DETECT) de ladite commande d'activation (KEY_ON), ledit circuit de détection (2) comprenant des moyens de génération (7, 9) d'un signal de défaut à partir d'un drapeau (LAMP_ON) signalant une défaillance dudit alternateur en reliant ladite ligne de communication (6) à une masse par au moins un élément de commutation à semi-conducteur (7) portant de ce fait ladite ligne de communication (6) à une seconde tension inférieure à une tension de défaut prédéterminée inférieure à ladite tension de référence haute, et ledit circuit de commande (1) comprenant des moyens de détection (4) dudit signal de défaut, **caractérisé en ce que** ledit circuit de commande (1) transmet en outre, via la ligne de communication, un signal de consigne modulé en largueur d'impulsion présentant un maximum supérieur à ladite tension de référence haute et un minimum inférieur à une tension de référence basse prédéterminée supérieure à ladite tension de défaut, un rapport cyclique dudit signal de consigne étant représentatif d'une tension de consigne (V0) dudit régulateur.

2. Dispositif de commande (1, 2) d'un régulateur d'un alternateur d'un véhicule automobile selon la revendication 1 précédente, **caractérisé en ce que** ledit circuit de détection (2) comprend en outre un premier comparateur de tension (20) activé par des moyens d'activation (24, 25) en l'absence de défaillance dudit alternateur et comparant un niveau de tension (V) de ladite ligne de communication (6) à un premier seuil de tension prédéterminé (V1).

3. Dispositif de commande (1, 2) d'un régulateur d'un alternateur d'un véhicule automobile selon la revendication 2 précédente, **caractérisé en ce que** ledit circuit de détection (2) comprend en outre un second comparateur de tension (21) activé par lesdits moyens d'activation (26) en cas de défaillance dudit alternateur et comparant ledit niveau de tension (V) de ladite ligne de communication (6) à un deuxième seuil de tension prédéterminé (V2).

4. Dispositif de commande (1, 2) d'un régulateur d'un alternateur d'un véhicule automobile selon la revendication 3 précédente, **caractérisé en ce que** lesdits moyens d'activation (24, 25, 26) sont formés par une première porte logique ET (24) connectée en entrée à une première sortie dudit premier comparateur de tension (20) et à un drapeau complémentaire dudit drapeau (LAMP_ON), et par une seconde porte logique ET (26) connectée en entrée à une seconde sortie dudit second comparateur de tension (21) et audit drapeau (LAMP_ON), lesdites première et seconde portes logiques ET (24, 26) étant connectées en sortie à une porte logique OU (27) de manière à reconstituer ledit signal de consigne (COM_DETECT).

5. Dispositif de commande (1, 2) d'un régulateur d'un alternateur d'un véhicule automobile selon l'une quelconque des revendications 3 ou 4 précédentes, **caractérisé en ce que** ledit circuit de détection (2) comprend en outre un amplificateur différentiel de tension (9) amplifiant une différence entre ledit niveau de tension (V) de ladite ligne de communication (6) et un troisième seuil de tension prédéterminé (V3), activé par ledit drapeau (LAMP_ON) et commandant ledit élément de commutation (7).

6. Dispositif de commande (1, 2) d'un régulateur d'un alternateur d'un véhicule automobile selon la revendication 2 précédente, **caractérisé en ce que** ledit circuit de détection (2) comprend en outre un comparateur de courant (29) activé par lesdits moyens d'activation (31) en cas de défaillance dudit alternateur et comparant une valeur du courant circulant dans ledit élément de commutation (7) à un seuil de courant prédéterminé.

7. Dispositif de commande (1, 2) d'un régulateur d'un alternateur d'un véhicule automobile selon la revendication 6 précédente, **caractérisé en ce que** lesdits moyens d'activation (31) sont formés par un multiplexeur à deux voies (31) commandé par ledit drapeau (LAMP_ON), et connecté en entrée à une première sortie dudit premier comparateur de tension (20) et à une seconde sortie dudit comparateur de courant (29) de manière à reconstituer ledit signal de consigne (COM_DETECT).

8. Dispositif de commande (1, 2) d'un régulateur d'un alternateur d'un véhicule automobile selon l'une quelconque des revendications 6 ou 7 précédentes, **caractérisé en ce que** ledit comparateur de courant (29) comprend un miroir de courant.

9. Dispositif de commande (1, 2) d'un régulateur d'un alternateur d'un véhicule automobile selon la revendication 8 précédente, **caractérisé en ce que** lesdites tensions de référence haute et basse prédéterminées, ladite tension de défaut, lesdits premier, deuxième et troisième seuils de tensions prédéterminés valent respectivement sensiblement 3,5 V, 1,5 V, 1,0 V, 2,5 V, 0,65 V et 0,9 V.

10. Alternateur de véhicule automobile du type de ceux comportant un régulateur intégré, **caractérisé en ce que** ledit régulateur comprend un circuit de détection (2) d'un dispositif de commande (1, 2) selon l'une quelconque des revendications 1 à 9 précédentes.

## Patentansprüche

1. Steuervorrichtung (1, 2) für einen Regler einer Lichtmaschine eines Kraftfahrzeugs vom Typ derjenigen, welche einerseits eine Steuerschaltung (1) aufweisen, die einen Befehl zur Aktivierung (KEY_ON) des Reglers erzeugt, indem sie eine erste Spannung, die höher als eine vorbestimmte hohe Referenzspannung ist, an eine eindrähtige bidirektionale Kommunikationsleitung (6) anlegt, die andererseits mit einer Schaltung zur Detektion (2) eines Zustands (KEY_DETECT) des Aktivierungsbefehls (KEY_ON) verbunden ist, wobei die Detektionsschaltung (2) Mittel zur Erzeugung (7, 9) eines Fehlersignals ausgehend von einem Flag (LAMP_ON), das einen Ausfall der Lichtmaschine signalisiert, durch Verbinden der Kommunikationsleitung (6) mit einer Masse durch wenigstens ein Halbleiterschaltelement (7) aufweist, wodurch an die Kommunikationsleitung (6) eine zweite Spannung angelegt wird, die niedriger als eine vorbestimmte Fehlerspannung ist, die niedriger als die hohe Referenzspannung ist, und wobei die Steuerschaltung (1) Mittel zur Detektion (4) des Fehlersignals umfasst,
**dadurch gekennzeichnet, dass** die Steuerschaltung (1) außerdem über die Kommunikationsleitung ein pulsweitenmoduliertes Sollwertsignal überträgt, welches ein Maximum aufweist, das höher als die hohe Referenzspannung ist, und ein Minimum, das niedriger als eine vorbestimmte niedrige Referenzspannung ist, die höher als die Fehlerspannung ist, wobei ein Tastverhältnis des Sollwertsignals für eine Sollwertspannung (V0) des Reglers repräsentativ ist.

2. Steuervorrichtung (1, 2) für einen Regler einer Lichtmaschine eines Kraftfahrzeugs nach dem vorhergehenden Anspruch 1, **dadurch gekennzeichnet, dass** die Detektionsschaltung (2) außerdem einen ersten Spannungskomparator (20) umfasst, der bei Nichtvorliegen eines Ausfalls der Lichtmaschine von Aktivierungsmitteln (24, 25) aktiviert wird und einen Spannungspegel (V) der Kommunikationsleitung (6) mit einem vorbestimmten ersten Spannungsschwellenwert (V1) vergleicht.

3. Steuervorrichtung (1, 2) für einen Regler einer Lichtmaschine eines Kraftfahrzeugs nach dem vorhergehenden Anspruch 2, **dadurch gekennzeichnet, dass** die Detektionsschaltung (2) außerdem einen zweiten Spannungskomparator (21) umfasst, der im Falle eines Ausfalls der Lichtmaschine von den Aktivierungsmitteln (26) aktiviert wird und den Spannungspegel (V) der Kommunikationsleitung (6) mit einem vorbestimmten zweiten Spannungsschwellenwert (V2) vergleicht.

4. Steuervorrichtung (1, 2) für einen Regler einer Lichtmaschine eines Kraftfahrzeugs nach dem vorhergehenden Anspruch 3, **dadurch gekennzeichnet, dass** die Aktivierungsmittel (24, 25, 26) von einem ersten UND-Gatter (24), das am Eingang mit einem ersten Ausgang des ersten Spannungskomparators (20) und mit einem zu dem Flag (LAMP_ON) komplementären Flag verbunden ist, und von einem zweiten UND-Gatter (26), das am Eingang mit einem zweiten Ausgang des zweiten Spannungskomparators (21) und mit dem Flag (LAMP_ON) verbunden ist, gebildet werden, wobei das erste und das zweite UND-Gatter (24, 26) am Ausgang mit einem ODER-Gatter (27) verbunden sind, um so das Sollwertsignal (COM_DETECT) abzuleiten.

5. Steuervorrichtung (1, 2) für einen Regler einer Lichtmaschine eines Kraftfahrzeugs nach einem der vorhergehenden Ansprüche 3 oder 4, **dadurch gekennzeichnet, dass** die Detektionsschaltung (2) außerdem einen Spannungsdifferenzverstärker (9) umfasst, der eine Differenz zwischen dem Spannungspegel (V) der Kommunikationsleitung (6) und einem vorbestimmten dritten Spannungsschwellenwert (V3) vergleicht, durch das Flag (LAMP_ON) aktiviert wird und das Schaltelement (7) steuert.

6. Steuervorrichtung (1, 2) für einen Regler einer Lichtmaschine eines Kraftfahrzeugs nach dem vorhergehenden Anspruch 2, **dadurch gekennzeichnet, dass** die Detektionsschaltung (2) außerdem einen Stromkomparator (29) umfasst, der im Falle eines Ausfalls der Lichtmaschine von den Aktivierungsmitteln (31) aktiviert wird und einen Wert des Stroms, der in dem Schaltelement (7) fließt, mit einem vorbestimmten Stromschwellenwert vergleicht.

7. Steuervorrichtung (1, 2) für einen Regler einer Lichtmaschine eines Kraftfahrzeugs nach dem vorhergehenden Anspruch 6, **dadurch gekennzeichnet, dass** die Aktivierungsmittel (31) von einem Zweiwege-Multiplexer (31) gebildet werden, der von dem Flag (LAMP_ON) gesteuert wird und am Eingang mit einem ersten Ausgang des ersten Spannungskomparators (20) und mit einem zweiten Ausgang des Stromkomparators (29) verbunden ist, um so das Sollwertsignal (COM_DETECT) abzuleiten.

8. Steuervorrichtung (1, 2) für einen Regler einer Lichtmaschine eines Kraftfahrzeugs nach einem der vorhergehenden Ansprüche 6 oder 7, **dadurch gekennzeichnet, dass** der Stromkomparator (29) einen Stromspiegel umfasst.

9. Steuervorrichtung (1, 2) für einen Regler einer Lichtmaschine eines Kraftfahrzeugs nach dem vorhergehenden Anspruch 8, **dadurch gekennzeichnet, dass** die vorbestimmte hohe und die vorbestimmte niedrige Referenzspannung, die Fehlerspannung, der erste, zweite und dritte vorbestimmte Spannungsschwellenwert ungefähr 3,5 V, 1,5 V, 1,0 V, 2,5 V, 0,65 V bzw. 0,9 V betragen.

10. Lichtmaschine eines Kraftfahrzeugs vom Typ derjenigen, welche einen integrierten Regler aufweisen, **dadurch gekennzeichnet, dass** der Regler eine Detektionsschaltung (2) einer Steuervorrichtung (1, 2) nach einem der vorhergehenden Ansprüche 1 bis 9 umfasst.

## Claims

1. Device (1, 2) for controlling a regulator of an alternator of a motor vehicle, of the type including firstly a control circuit (1) generating a command (KEY_ON) to activate said regulator by bringing, to a first voltage greater than a predetermined high reference voltage, a single-wire bidirectional communication line (6) that is connected, secondly, to a circuit (2) for detecting a state (KEY_DETECT) of said activation command (KEY_ON), said detection circuit (2) comprising means (7, 9) for generating a fault signal on the basis of a flag (LAMP_ON) signalling a fault with said alternator by connecting said communication line (6) to ground using at least one semiconductor switching element (7) thereby bringing said communication line (6) to a second voltage lower than a predetermined fault voltage lower than said high reference voltage, and said control circuit (1) comprising means (4) for detecting said fault signal, **characterized in that** said control circuit (1) furthermore transmits, via the communication line, a pulse width-modulated setpoint signal having a maximum greater than said high reference voltage and a minimum lower than a predetermined low reference voltage greater than said fault voltage, a duty cycle of said setpoint signal being representative of a setpoint voltage (V0) of said regulator.

2. Device (1, 2) for controlling a regulator of an alternator of a motor vehicle according to preceding Claim 1, **characterized in that** said detection circuit (2) furthermore comprises a first voltage comparator (20) activated by activation means (24, 25) in the absence of a fault with said alternator and comparing a voltage level (V) of said communication line (6) with a predetermined first voltage threshold (V1).

3. Device (1, 2) for controlling a regulator of an alternator of a motor vehicle according to preceding Claim 2, **characterized in that** said detection circuit (2) furthermore comprises a second voltage comparator (21) activated by said activation means (26) in the event of a fault with said alternator and comparing said voltage level (V) of said communication line (6) with a predetermined second voltage threshold (V2).

4. Device (1, 2) for controlling a regulator of an alternator of a motor vehicle according to preceding Claim 3, **characterized in that** said activation means (24, 25, 26) are formed by a first logic AND gate (24) connected at input to a first output of said first voltage comparator (20) and to a flag complementary to said flag (LAMP_ON), and by a second logic AND gate (26) connected at input to a second output of said second voltage comparator (21) and to said flag (LAMP_ON), said first and second logic AND gates (24, 26) being connected at output to a logic OR gate (27) so as to reconstitute said setpoint signal (COM_DETECT) .

5. Device (1, 2) for controlling a regulator of an alternator of a motor vehicle according to either one of preceding Claims 3 and 4, **characterized in that** said detection circuit (2) furthermore comprises a differential voltage amplifier (9) amplifying a difference between said voltage level (V) of said communication line (6) and a predetermined third voltage threshold (V3), activated by said flag (LAMP_ON) and commanding said switching element (7).

6. Device (1, 2) for controlling a regulator of an alternator of a motor vehicle according to preceding Claim 2, **characterized in that** said detection circuit (2) furthermore comprises a current comparator (29) activated by said activation means (31) in the event of a fault with said alternator and comparing a value of the current flowing in said switching element (7) with a predetermined current threshold.

7. Device (1, 2) for controlling a regulator of an alternator of a motor vehicle according to preceding Claim 6, **characterized in that** said activation means (31) are formed by a dual-channel multiplexer (31) commanded by said flag (LAMP_ON) and connected at input to a first output of said first voltage comparator (20) and to a second output of said current comparator (29) so as to reconstitute said setpoint signal (COM_DETECT) .

8. Device (1, 2) for controlling a regulator of an alternator of a motor vehicle according to either one of preceding Claims 6 and 7, **characterized in that** said current comparator (29) comprises a current mirror.

9. Device (1, 2) for controlling a regulator of an alternator of a motor vehicle according to preceding Claim 8, **characterized in that** said predetermined high and low reference voltages, said fault voltage and said predetermined first, second and third voltage thresholds have values of substantially 3.5 V, 1.5 V, 1.0 V, 2.5 V, 0.65 V and 0.9 V, respectively.

10. Motor vehicle alternator of the type including an integrated regulator, **characterized in that** said regulator comprises a detection circuit (2) of a control device (1, 2) according to any one of preceding Claims 1 to 9.
